Europäisches Patentamt

European Patent Office

Office européen des brevets

(11) Publication number: **0 181 975**
**B1**

# EUROPEAN PATENT SPECIFICATION

(45) Date of publication of patent specification: **29.03.89**

(51) Int. Cl.⁴: **H 01 L 23/14**

(21) Application number: **84307918.7**

(22) Date of filing: **15.11.84**

(54) Semiconductor device comprising a support body.

(43) Date of publication of application:
**28.05.86 Bulletin 86/22**

(45) Publication of the grant of the patent:
**29.03.89 Bulletin 89/13**

(84) Designated Contracting States:
**DE FR GB**

(56) References cited:
**EP-A-0 018 174**
**DE-A-3 221 199**

**32nd ELECTRONIC COMPONENTS
CONFERENCE, San Diego, California, 10th-12th
May 1982, pages 158-165, IEEE, New York, US;
L.M. MAHALINGAM et al.: "Thermal design
studies of a high current transistor package"**

(73) Proprietor: **FUJI ELECTRIC CO., LTD.**
**1-1, Tanabeshinden, Kawasaki-ku
Kawasaki-shi Kanagawa 210 (JP)**

(72) Inventor: **Nihei, Kazuya
Fuji Denki Tsukama-Ryo Tsukama 2530
Matsumoto-shi Nagano-ken 390 (JP)**

(74) Representative: **Gordon, Martin et al
G.F. Redfern & Company Marlborough Lodge 14
Farncombe Road
Worthing West Sussex, BN11 2BT (GB)**

Courier Press, Leamington Spa, England.

## Description

The present invention relates to semiconductor devices and in particular to such devices in which semiconductor elements are mounted on electrically conductive surfaces of support members intended to act as heat sinks.

One form of such an arrangement is disclosed in 32nd ELECTRONIC COMPONENTS CONFERENCE, San Diego, California, 10-12 May 1982, pages 158-165, IEEE, New York; US; L. M. MAHALINGAM et al: "Thermal Design Studies of a High Current Transistor Package". This arrangement uses a copper plate as support member which has an integrally-formed extended portion arranged to act as collector terminal. Base and emitter terminals are secured to the upper surface of the support member. However, it is often not convenient or possible to form one of the terminals (the collector terminal in the prior art arrangement) integrally with the support member so that all the terminals have to be secured to the upper surface of the support member.

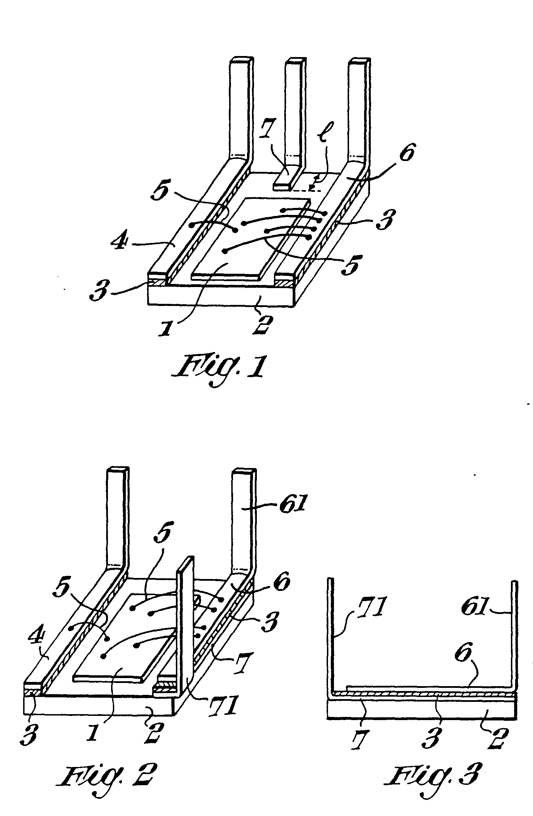

A previously-proposed device is shown in Fig. 1 and here a semiconductor element in the form of a transistor has three terminals. More particularly, a transistor chip 1 is brazed on to a metal plate 2 commonly used as a heat sink such that the collector of the transistor makes electrical contact with the plate 2. A base electrode on the upper surface of the chip 1 is connected to the upper surface of a base terminal 4 (by means of an aluminium wire 5) fixed to the plate 2 but insulated from the latter by means of a ceramic board 3. The emitter electrode is connected (by means of an aluminium wire 5) to the upper surface of an emitter terminal 6 fixed to but insulated from the plate 2 by means of a ceramic board 3. On the other hand, since the collector is connected to the plate 2, a collector terminal 7 is brazed directly on to the plate 2 in a position spaced from the flank of the chip 1.

Both the base and emitter terminals 4, 6 are bent so as to extend perpendicularly to major surfaces of the plate 2 and one end of each of the terminals is arranged to protrude from a sealing resin (not shown) for enclosing (encapsulating) and protecting the chip 1. The protruding terminal portions can then be utilized to make contact with an external circuit. In this case, the portion of the collector terminal 7 secured to the plate 2 needs a certain length l to provide secure adhesive strength, so that the plate 2 must be long enough to accommodate the collector terminal 7 so that the area occupied by the semiconductor device is relatively large.

It is an object of the present invention to provide a semiconductor device arranged to make optimum use of its area while providing optimum strength for the connections of the terminals to the support body.

According to this invention there is provided a semiconductor device comprising a support body having an electrically conductive surface to which is secured a semiconductor element having a plurality of electrodes connected to terminal portions having extended portions for external connection of the device and one of the electrodes being in direct electrical contact with said conductive surface which is electrically connected to a first terminal portion, said semiconductor device being characterised in that said first terminal portion is mounted on and secured to said conductive surface along an edge portion of the latter, and another of the electrodes has an electrical connection to a second terminal portion overlying and supported by, but insulated from, said first terminal portion, the lengths of the superimposed terminal portions extending substantially over the length of the semiconductor element whereby the first terminal portion is provided with a connection to the conductive surface which is at least as extensive as the second terminal portion.

Embodiments of this invention will now be described, by way of example, with reference to the accompanying drawing in which:-

Fig. 1 is a perspective view of a conventional semiconductor device prior to encapsulation;

Fig. 2 is a perspective view of a first form of semiconductor device embodying this invention and prior to encapsulation; and

Fig. 3 is a side view of a second form of semiconductor device embodying this invention and prior to encapsulation.

In Fig. 2 like reference characters designate like or corresponding portions or elements to those of the device shown in Fig. 1.

The device shown in Fig. 2 comprises a similar arrangement to that shown in Fig. 1 except in that a collector terminal 7 is brazed on to the plate 2 along the edge portion of the plate opposite the edge portion carrying the base terminal 4 with the chip 1 positioned between the two edge portions. The emitter terminal 6 is secured to an electrically insulating ceramic board 3 secured on to the collector terminal 7. In this case, one end of the insulating board 3 is slightly exposed since the emitter terminal stops sufficiently short of upright terminal portion 71 of the collector terminal 7 to maintain insulation between the emitter and collector terminals. The terminals 4, 6, 7 are bent to extend upright from the relevant major surface of the plate 2 as in the device shown in Fig. 1, but in the device shown in Fig. 2 the terminal portions 61, 71 have their major surfaces at right angles to each other and the upright portion 71 of the collector terminal is positioned substantially opposite the portion 61 of the emitter terminal 6.

In the device shown in Fig. 2, the upright terminal portion 71 is arranged to emerge laterally from the collector terminal 7. However, as shown in Fig. 3, the upright portion 71 may be provided with its major surfaces parallel with and directly opposite the upright portion 61 of the emitter terminal. In either case, it is possible to arrange for the emitter terminal 6 to be connected to the emitter electrode by means of an aluminium wire 5 as in the conventional device.

In the semiconductor device thus constructed, the length of the plate 2 needs to be only slightly greater than the length of the semiconductor chip 1 and may thus be effectively shortened by a length l compared with the device shown in Fig. 1.

The embodiments described above are highly effective in making compact electronic devices because the size of the plate for supporting the semiconductor element in the semiconductor device, that is, the area occupied by the semiconductor device can be minimized by laying the terminal connected to the electrode on the exposed surface of the semiconductor element, over the terminal directly connected to the plate with an intervening layer of insulating material between the terminals. The present invention may also be applicable to other semiconductor devices such as thyristors having three terminals or those with four terminals such as transistors in Darlington pair connection.

The embodiments described above thus each provide a semiconductor device comprising a support body (2) having an electrically conductive surface to which is secured a semiconductor element (1) having a plurality of electrodes one of which is in direct electrical contact with said conductive surface which is electrically connected to a first terminal portion (7), and another of which electrodes has an electrical connection (5) to a second terminal portion (6) overlying and supported by, but insulated (3) from, said first terminal portion (7), said terminal portions having extended portions (61, 71) for external connection of the device.

## Claims

1. A semiconductor device comprising a support body (2) having an electrically conductive surface to which is secured a semiconductor element (1) having a plurality of electrodes connected to terminal portions (4, 6, 7) having extended portions for external connection of the device and one of the electrodes being in direct electrical contact with said conductive surface which is electrically connected to a first terminal portion (7), said semiconductor device being characterised in that said first terminal portion (7) is mounted on and secured to said conductive surface along an edge portion of the latter, and another of the electrodes has an electrical connection to a second terminal portion (6) overlying and supported by, but insulated (3) from, said first terminal portion (7), the lengths of the superimposed terminal portions (6, 7) extending substantially over the length of the semiconductor element (1) whereby the first terminal portion (7) is provided with a connection to the conductive surface which is at least as extensive as the second terminal portion (6).

2. A semiconductor device according to claim 1 wherein the semiconductor element has a third electrode electrically connected to a third terminal portion overlying and supported by, but insulated from, said conductive surface.

3. A semiconductor device according to claim 2 wherein said semiconductor element lies between said first and third terminal portions.

4. A semiconductor device according to claim 3 wherein said semiconductor element is a transistor and said third electrode is the base electrode.

5. A semiconductor device according to any one of the preceding claims wherein said first terminal portion comprises a conductive strip element secured to the conductive surface.

6. A semiconductor device according to any one of the preceding claims wherein said extended portions extend substantially perpendicularly relative to said conductive surface.

7. A semiconductor device according to any one of the preceding claims wherein said first terminal portion is a strip portion having a lateral extension forming said extended portion.

8. A semiconductor device according to any one of claims 1 to 6 wherein said first and second terminal portions are strip portions having their extended portions at opposite ends.

9. A semiconductor device according to any one of the preceding claims wherein said support body is a metal plate arranged to act as a heat sink.

## Patentansprüche

1. Halbleiteranordnung mit einem Trägerkörper (2), der eine elektrisch leitende Oberfläche aufweist, an der ein Halbleiterelement (1) befestigt ist, das eine Vielzahl von Elektroden besitzt, die mit Anschlüssen (4, 6, 7) verbunden sind, die Verlängerungen zum externen Anschluß der Anordnung aufweisen und wobei eine der Elektroden in direktem Kontakt mit der leitenden Oberfläche steht, die elektrisch mit dem ersten Anschluß (7) verbunden ist und wobei die Halbleiteranordnung dadurch gekennzeichnet ist, daß der erste Anschluß (7) an der und mit der leitenden Oberfläche entlang einer ihrer Kanten verbunden ist und eine andere der Elektroden eine elektrische Verbindung zu einem zweiten Anschluß (6) hat, der den ersten Anschluß (7) überlagert, von diesem getragen aber davon isoliert (3) ist, daß die Länge der sich überlagernden Anschlüsse (6, 7) sich im wesentlichen über die Länge des Halbleiterelementes (1) erstreckt, wobei der erste Anschluß (7) mit einer Verbindung zu der leitenden Oberfläche versehen ist, die wenigstens so ausgedehnt ist wie der zweite Anschluß (6).

2. Halbleiteranordnung nach Anspruch 1, wobei das Halbleiterelement eine dritte Elektrode aufweist, die elektrisch mit einem dritten Anschluß verbunden ist, der die leitende Oberfläche überlagert, von dieser getragen aber davon isoliert ist.

3. Halbleiteranordnung nach Anspruch 2, wobei das Halbleiterelement zwischen dem ersten und dem dritten Anschluß liegt.

4. Halbleiteranordnung nach Anspruch 3, wobei das Halbleiterelement ein Transistor und die dritte Elektrode die Basiselektrode ist.

5. Halbleiteranordnung nach einem der vorstehenden Ansprüche, wobei der erste Anschluß ein Leiterstreifen ist, der an der leitenden Oberfläche befestigt ist.

6. Halbleiteranordnung nach einem der vorstehenden Ansprüche, wobei die Verlängerungen sich im wesentlichen senkrecht zu der leitenden Oberfläche erstrecken.

7. Halbleiteranordnung nach einem der vorstehenden Ansprüche, wobei der erste Anschluß ein Streifen ist, der eine laterale Erstreckung aufweist, die die Verlängerung bildet.

8. Halbleiteranordnung nach einem der Ansprüche 1 bis 6, wobei der erste und der zweite Anschluß Streifen sind, die ihre Verlängerungen an gegenüber liegenden Enden haben.

9. Halbleiteranordnung nach einem der vorstehenden Ansprüche, wobei der Trägerkörper eine Metallplatte ist, die als Kühlblech wirkt.

**Revendications**

1. Dispositif semiconducteur comprenant un corps de support (2) présentant une surface électriquement conductrice à laquelle est fixé un élément semiconducteur (1) comprenant plusieurs électrodes reliées à des portions de bornes (4, 6, 7) comprenant des portions prolongées en vue d'une connexion externe du dispositif et l'une des électrodes étant en contact électrique direct avec ladite surface conductrice qui est électriquement reliée à une première portion de borne (7), ledit dispositif semiconducteur étant caractérisé en ce que ladite première portion de borne (7) est montée sur et fixée à ladite surface conductrice le long d'une portion de bord de cette dernière, et une autre des électrodes comprend une connexion électrique avec une seconde portion de borne (6) recouvrant et supportée par, mais isolée (3) vis-à-vis de la première portion de borne (7), les longueurs des portions de bornes superposées (6, 7) s'étendant sensiblement sur la longueur de l'élément semiconducteur (1), la première portion de borne (7) étant munie d'une connexion avec la surface conductrice qui est au moins de même étendue que la seconde portion de borne (6).

2. Dispositif semiconducteur selon la revendication 1, dans lequel l'élément semiconducteur comprend une troisième électrode reliée électriquement à une troisième portion de borne recouvrant et supportée par, mais isolée vis-à-vis de ladite surface conductrice.

3. Dispositif semiconducteur selon la revendication 2, dans lequel ledit élément semiconducteur est disposé entre lesdites première et troisième portions de bornes.

4. Dispositif semiconducteur selon la revendication 3, dans lequel ledit élément semiconducteur est un transistor et ladite troisième électrode est l'électrode de base.

5. Dispositif semiconducteur selon l'une quelconque des revendications précédentes, dans lequel ladite première portion de borne comprend un élément en forme de bande conductrice fixé à la surface conductrice.

6. Dispositif semiconducteur selon l'une quelconque des revendications précédentes, dans lequel lesdites portions prolongées s'étendent sensiblement perpendiculairement à ladite surface conductrice.

7. Dispositif semiconducteur selon l'une quelconque des revendications précédentes, dans lequel ladite première portion de borne est une portion de bande présentant un prolongement latéral formant ladite portion prolongée.

8. Dispositif semiconducteur selon l'une quelconque des revendications 1 à 6, dans lequel lesdites première et seconde portions de bornes sont des portions de bandes dont les portions prolongées sont à leurs extrémités opposées.

9. Dispositif semiconducteur selon l'une quelconque des revendications précédentes, dans lequel ledit corps de support est une plaque métallique aménagée pour agir en tant que dissipateur de chaleur.

Fig. 1

Fig. 2

Fig. 3